(19)

Europäisches
Patentamt
European
Patent Office
Office européen
des brevets

(11) **EP 3 182 243 A1**

(12) **EUROPEAN PATENT APPLICATION**

(43) Date of publication:
**21.06.2017 Bulletin 2017/25**

(51) Int Cl.:
**G05F 1/575** (2006.01)

(21) Application number: **15201321.5**

(22) Date of filing: **18.12.2015**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(71) Applicant: **ams AG
8141 Unterpremstätten (AT)**

(72) Inventors:
• **Fiocchi, Carlo
27011 Belgioioso (PV) (IT)**
• **Cerchi, Marco
27050 Cornale (IT)**

(74) Representative: **Epping - Hermann - Fischer
Patentanwaltsgesellschaft mbH
Schloßschmidstraße 5
80639 München (DE)**

(54) **ACTIVE POTENTIOMETER CIRCUIT**

(57)    In one embodiment an active potentiometer circuit has an input (1) which is adapted to receive an input current (Iin), a current buffer component (CB) which has a first buffer input (2) which is coupled to the input (1), a second buffer input (3) and a buffer output (4) at which a buffered current (Is) is provided as a function of the input current (Iin), and a resistor (R) which is coupled between the current buffer output (4) and a reference potential terminal (10),. The buffer output (4) is coupled to the second buffer input (3) and a voltage drop (Vd) across the resistor (R) is coupled to the second buffer input (3) such that a potential of the first buffer input (2) is adjusted to a potential at the second buffer input (3).

FIG 1

EP 3 182 243 A1

**Description**

The application concerns an active potentiometer circuit.

The field of the application concerns digital potentiometers.

A commonly known potentiometer enables realizing a resistor with adjustable resistance value. The resistance value is usually adjusted by means of a digital control. Due to the electric control, such potentiometer is fit to be inserted, for instance, in a control regulation loop. The potentiometer value, as well as the number of digits for the control, might vary in a very large range.

However, the achievable accuracy with respect to the resistance value is limited for several reasons: first, the matching of partial resistors which implement the resistor is a key feature to ensure, like in a digital-to-analog converter, the desired accuracy in terms of integral and differential linearity. Second, as the digital setting is accomplished by means of switches, their on resistance must have a negligible impact on the final value of the resistor. In fact switches are not linear and undergo a remarkable spread with respect to temperature and supply voltage. Third, the specific resistance of the integrated partial resistors suffers from 20 percent inaccuracy. Finally, the voltage drop across the resistor might be very large. To ensure high voltage robustness it is mandatory to provide complementary metal-oxide semiconductor, CMOS, switches having a large drain area as well as a channel length significantly bigger than the minimum length allowed in lithography. The resulting impact on the area is usually severe.

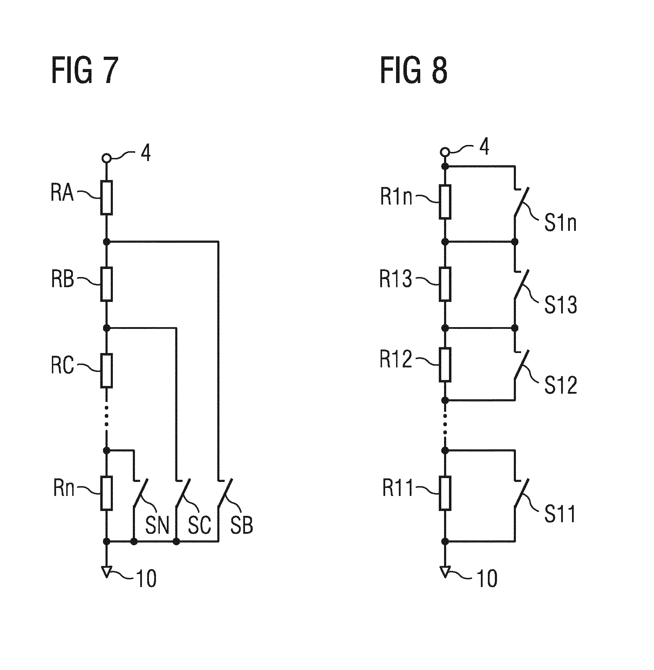

Known implementations of digital or electronic potentiometers are based on a serial connection of a number of partial resistors. Switches which are usually realized as CMOS transistors are arranged such that the value of a resistance between the two terminals of the serial connection can be adjusted using digital input signals and a digital control. Two alternative solutions of the state of the art are shown in Figures 7 and 8.

The solution of Figure 7 foresees $2^N$-1 equal taps realized by resistors RA, RB, RC, ..., Rn, wherein N represents the number of digits for adjustment. Each of these resistors is shorted to the lower terminal 10 which in this case is a reference potential terminal or ground by a number of switches SB, SC, ..., SN. This solution is intrinsically monotonic and has all the switches with a common terminal. This simplifies the implementation of a switch driving circuitry.

The alternative solution of Figure 8 has n binary weighted taps realized as resistors R11, R12, R13, ..., R1n. The resistance values of the resistors correspond to a product of an adjustable basic resistance value r and two to the power of the position of the corresponding resistor. Thereby, resistor R11 has the resistance r; resistor R12 has the resistance r multiplied by two; resistor R13 has the resistance r multiplied by four; resistor R1n has the resistance r multiplied by two to the power of n minus one. Each of the resistors R11, R12, R13, ..., R1n is bypassed by a corresponding switch. Consequently, resistor R11 is bypassed by switch S11, resistor R12 is bypassed by switch S12, resistor R13 is bypassed by switch S13, and resistor R1n is bypassed by switch S1n. The use of binary weighted taps eliminates the need of a decoder and provides very few interconnections for an easy layout. However, the switches must be driven in a different way all of them, due to the fact that the voltage at their terminals depends on the digital word and differs from tap to tap.

The state of the art solutions of Figure 7 and 8 are not adequate for the following particular needs:

First, none of them can be trimmed: it is really unpractical to think that each tap can be finely tuned to few percent accuracy once the spread of an integrated resistor can be as large as +/- 20%. This is very questionable for the solution with binary weighted taps of Figure 8 and absolutely unrealistic for the other one.

Next, in case the resistance to be generated is quite small, each resistor must be implemented with many resistors in parallel to ensure adequate matching. In this way the smaller resistor becomes the one that wastes more area. The approach of Figure 7 is consequently rendered unpractical and in both solutions the situation would lead to undesirable switch sizes.

Finally, regarding a high voltage application, another problem of the solution in Figure 8 is evident: as each switch has a limited control voltage for reliability concerns, it is not possible to use one single voltage source that safely drives their gates. This problem is not met in the solution in Figure 7, where each switch overdrive is referred to the same voltage.

It is therefore an object to provide a potentiometer with improved behavior, for example with respect to high voltage requirements and trimming of the obtained resistance.

The object is achieved by the subject matter of the independent claim. Embodiments and developments are subject matter of the dependent claims.

In one embodiment, an active potentiometer circuit has an input which is adapted to receive an input current, a current buffer component and a resistor. The current buffer component has a first buffer input which is coupled to the input, a second buffer input and a buffer output. At the buffer output a buffered current is provided as a function of the input current. The resistor is coupled between the current buffer output and a reference potential terminal. The buffer output is coupled to the second buffer input and a voltage drop across the resistor is coupled to the second buffer input such that a potential of the first buffer input is adjusted to a potential at the second buffer input.

The input current is buffered by the current buffer component. The input current is steered across the resistor and the voltage drop generated across said resistor sets a virtual ground at the current buffer inputs. By this the voltage drop across the resistor is determined by the buffered current multiplied by the resistance of the resistor. Because of the current buffer component, the buffered current substantially corresponds to the input current.

Consequently, a voltage drop between the input and the reference potential terminal is proportional to the input current by means of a rational function corresponding to the equivalent impedance at the input which is basically determined by the resistor. This improves the behaviour of the active potentiometer because it reduces the dynamic range and minimizes the use of high-voltage components.

The resistor can be implemented for example by using the solution depicted in Figure 7 or the solution depicted in Figure 8.

In one development, the current buffer component comprises a first operational amplifier and a transistor coupled to an output of the first operational amplifier.

In a further development, a positive input terminal of the first operational amplifier forms the first buffer input. A negative input terminal of the first operational amplifier forms the second buffer input. An output of the first operational amplifier is coupled to a control input of the transistor. A controlled section of the transistor is connected between the input of the active potentiometer circuit and the buffer output of the current buffer component.

Said transistor is preferably implemented as a CMOS component.

According to a development in a first alternative, a resistor divider is provided having a first and a second resistor being connected in series between the input of the active potentiometer circuit and the reference potential terminal such that the first buffer input is coupled to the active potentiometer circuit input by means of the first resistor.

The equivalent input impedance is consequently given by the product of the resistor with the sum of one and the quotient of first resistor and second resistor. By dimensioning the quotient or ratio of first and second resistor sufficiently large for a given target input impedance, the voltage drop across the resistor is small enough to implement the resistor without using high voltage devices. This achieves a remarkable improvement with respect to the area, because only the transistor of the current buffer component has to be implemented with a drain extension.

In a further development one of first and second resistors has an adjustable resistance value.

By adjusting the ratio of first and second resistor, the input impedance can be trimmed by a scaling factor which is independent of the absolute value of the input impedance.

In other words, the current buffer component steers the input current onto the resistor. The resistor divider implements a trimming and voltage scaling functionality, so that the resistor can be implemented by means of low voltage components e.g. the solutions depicted in Figure 7 or 8 using low voltage transistors for the switches. The resulting resistance of the active potentiometer circuit is set by adjusting the resistance of the resistor.

The action of trimming a resistance value is necessitated by the production variation and depends on the lot of production. The action of setting is repetitive in a potentiometer. By way of example, for setting a resistance value 1000 steps are available, whereas for trimming 32 or 64 steps are used.

In another alternative, a multiplier component is provided which is connected between the buffer output and the second buffer input. The input of the active potentiometer circuit is directly connected to the first current buffer input.

In this alternative, the voltage drop across the resistor is amplified by the multiplier component, thereby determining the virtual ground of the current buffer component and the voltage drop at the input of the active potentiometer circuit.

In a development the multiplier component comprises a second operational amplifier with a non-inverting input terminal which is coupled to the current buffer output, an inverting input terminal and an output which is connected to the second buffer input.

In one development, a second resistor divider is provided having a third and a fourth resistor being connected in series between the output of the second operational amplifier and the reference potential terminal. A connection point between third and fourth resistor is coupled to the inverting input terminal of the second operational amplifier.

The equivalent input impedance in this alternative is represented by the product of the resistor with the sum of one and the ratio of third and fourth resistors.

In a development one of third and fourth resistors has an adjustable resistance value.

In this alternative, the roles of trimming and setting may be swapped when compared with the first alternative described above. This means that in this alternative the resistor is trimmed. The resulting resistance value realized by the active potentiometer circuit is achieved by adjusting the value of e.g. the third resistor. Thereby, the desired accuracy of the potentiometer circuit is ensured despite the spread of the factory process. Consequently, in this alternative one of the architectures depicted in Figure 7 or Figure 8 can be used to implement the third resistor.

In a development the resistor has a digitally adjustable resistance value.

In both described alternatives, the resistor is crossed by the considerably large buffered current.

In one embodiment, the resistor comprises a serial connection of an amount of n partial resistors and a multiplexer component which has a number of n multiplexer switches. The resistances of the n partial resistors are substantially or nominally equal. Each multiplexer switch couples one connection point in the serial connection of partial resistors to an output of the multiplexer component. Said output is connected to the second buffer input of the current buffer component.

By means of the multiplexer component a suitable tap within the string of partial resistors is selected in order to provide the desired resistance value for the resistor.

In case this implementation possibility of the resistor is used in the first alternative described above, it turns out that due to the infinite impedance at the input of the current buffer component, the switches realizing the multiplexer component can be minimum sized. As any component of the resistor is scaled down to a low voltage range, the switches can be implemented by usual transmission gates with CMOS logic.

In one development, the resistor further comprises a bypass circuit having a number of n bypass switches. Each bypass switch is coupled between the buffer output and the reference potential terminal. Each bypass switch is adapted to bypass one corresponding partial resistor in a switchable manner.

The bypass circuit is provided in order to save the dynamic range of the transistor of the current buffer component. The bypass switches can be designed to be moderately conducting.

In an alternative, the resistor comprises a serial connection of an amount of n fractional resistors and a number of n-1 shortening switches. Each shortening switch is adapted to connect one connection point between two fractional resistors of the serial connection to the reference potential terminal in a switchable manner. The resistances of the n fractional resistors are substantially equal.

This implementation corresponds to the well-known implementation of the state of the art. However, here the active potentiometer circuit is used which enables implementing the shortening switches by using a low voltage process and thereby reducing area consumption.

In another alternative, the resistor comprises a serial connection of an amount of n divisional resistors and a number of n eliminating switches. Each eliminating switch is adapted to bypass one corresponding divisional resistor in a switchable manner. The resistance of each of the n divisional resistors corresponds to the product of an adjustable basic resistance value and two to the power of the position of the corresponding divisional resistor such that binary weighted caps are formed within the serial connection of divisional resistors.

This implementation of the resistor corresponds to the one depicted in Figure 8. As this implementation is used in the active potentiometer circuit, its switches can be implemented by a low voltage process which is not possible in a state of the art digital potentiometer.

The text below explains the proposed active potentiometer circuit in detail using exemplary embodiments with reference to the drawings. Components and circuit elements that are functionally identical or have the identical effect bear identical reference numbers. In so far as circuit parts or components correspond to one another in function, a description of them will not be repeated in each of the following figures.

Figure 1     shows a first embodiment of the proposed active potentiometer circuit;

Figure 2     shows a second embodiment of the proposed active potentiometer circuit;

Figure 3     shows an example for implementing the resistor as proposed;

Figure 4     shows an exemplary embodiment of an active potentiometer circuit with an implementation of the resistor as proposed;

Figure 5     shows an equivalent circuit of the embodiment of Figure 4;

Figure 6     shows another embodiment example of the active potentiometer circuit as proposed;

Figure 7     shows a resistor implementation example; and

Figure 8     shows another resistor implementation example.

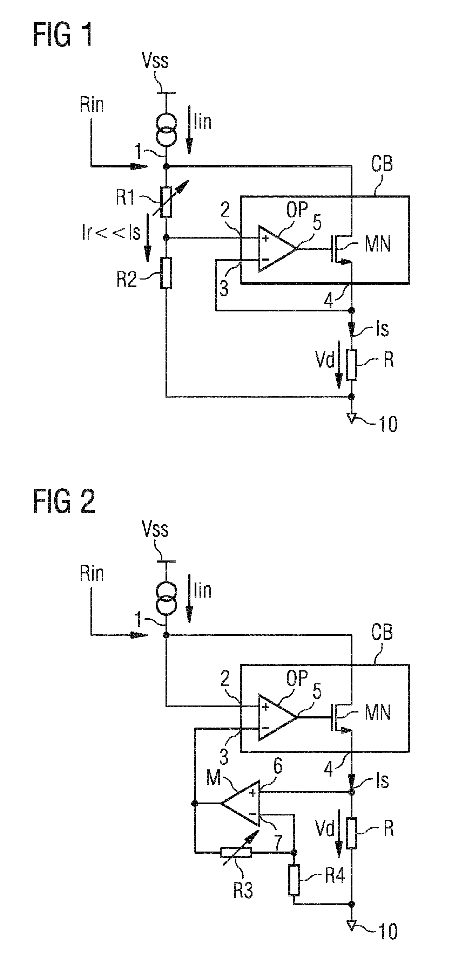

Figure 1 shows a first embodiment of the proposed active potentiometer circuit. The circuit comprises an input 1, a current buffer component CB with a first buffer input 2, a second buffer input 3 and a buffer output 4 and a resistor R. The active potentiometer circuit further comprises a resistor divider R1, R2 which has a first resistor R1 and a second resistor R2 which are connected in series between the input 1 of the active potentiometer circuit and a reference potential terminal 10. A connection point between the first and the second resistor R1, R2, is coupled to the first buffer input 2 of the current buffer component CB. The resistor R is coupled between the buffer output 4 and the reference potential terminal 10.

The current buffer component CB comprises a first operational amplifier OP and a transistor MN. The first operational amplifier OP has a non-inverting input representing the first buffer input 2 which is coupled to the connection point between first resistor R1 and second resistor R2. Furthermore, the first operation amplifier OP has an inverting input which forms second buffer input 3 and an output 5. The inverting input is connected with the output 4 of the current buffer component CB. A control input of transistor MN is coupled to the output 5 of the first operation amplifier OP. A controlled section of the transistor MN is connected between the input 1 of the active potentiometer circuit and the output 4 of the current buffer component CB. Transistor MN is preferably realized as an NMOS transistor with its drain terminal being connected to the input 1 and its source terminal representing the output 4 of the current buffer component CB.

An input current Iin is supplied to the input 1 by means of a current source which is also connected to a supply potential terminal Vss.

The input current Iin is buffered by the active components of the current buffer component CB, i.e. by means of the first operational amplifier OP and the transistor MN such that at the output 4 of the current buffer component CB a buffered current Is is provided in function of the input current Iin. A voltage drop Vd across the resistor R is coupled to the inverting input of the first operational amplifier OP. Due to the infinite input impedance of the first operation amplifier OP this voltage drop Vd sets the virtual ground at the current buffer component inputs 2, 3.

The first and the second resistors R1 and R2 are dimensioned such that they are sufficiently large with respect to the resistor R. Consequently, a resistor current Ir across the first resistor R1 can be neglected. It follows that the majority of the input current Iin is steered onto the resistor R as the buffered current Is. Therefore, the voltage at the input 1 is determined by the input current Iin and an equivalent input impedance Rin.

One of first and second resistors R1, R2 has an adjustable resistance value. It can be calculated that the equivalent input impedance Rin which is realized at the input 1 of the active potentiometer circuit is calculated by the following equation:

$$Rin = R * \left(1 + \frac{R1}{R2}\right)$$

wherein Rin represents the input impedance Rin, R represents the resistor R, R1 represents the first resistor R1 and R2 represents the second resistor R2.

For implementing the resistor R different approaches can be chosen. Supposing that the well-known techniques of Figure 7 or Figure 8 are used, and the ratio of first and second resistors R1, R2, is sufficiently large for a given target of the input impedance Rin, the voltage drop Vd across the resistor R is small enough to implement this resistor without using high voltage devices. Thereby area consumption is greatly reduced. Only transistor MN must be implemented with a drain extension for sustaining a possibly high voltage at input 1. Furthermore, as the ratio of first and second resistors R1, R2 can be tuned by adjusting either the value of the first resistor R1 or of the second resistor R2, it is possible to trim the input impedance Rin independently of its absolute value.

As the person skilled in the art knows, a possible offset of the first operational amplifier shall be corrected in order to achieve high accuracy even for the lowest values of the resistor R and also for good linearity.

Regarding the voltage drop Vd across the resistor R, for any value of the input current Iin the transistor MN can be designed to always operate properly and drive all of the input current Iin by realizing transistor MN with a small on-resistance. This can be achieved by choosing a large ratio of width to length of the transistor MN. Therefore, taking into account the above equation for the input impedance Rin, the on-resistance Ron of the transistor MN has to be chosen to be smaller than the product of the resistor R and the ratio of the first and the second resistor R1, R2. As already discussed above, the ratio of first and second resistors R1, R2 is designed to be sufficiently large, it is clear that correct operation of the active potentiometer circuit is always assured, even for the smallest value of the resistor R.

In short, by using the active components of the current buffer component CB the resistor R can be implemented using low voltage switches, thereby saving chip area.

The value of the resistance is adjusted by setting the resistor R. This value can be further trimmed by adjusting the value of the first or the second resistor R1, R2. As depicted in Figure 1, the first resistor R1 is realized with variable resistance, so the first resistor R1 would be used for trimming in this example.

Figure 2 shows a second embodiment of the proposed active potentiometer circuit. The embodiment depicted in Figure 2 represents an alternative to the embodiment depicted in Figure 1. The active potentiometer circuit shown in Figure 2 comprises the input 1, the current buffer component CB and the resistor R as described in Figure 1. In addition, this embodiment comprises a multiplier component M and a second resistor divider R3, R4. In contrast to the embodiment of Figure 1, the non-inverting input of the first operation amplifier OP of the current buffer component CB is directly coupled to the input 1. The multiplier component M comprises a second operational amplifier with a non-inverting input 6 which is coupled to the buffer output 4 of the current buffer component CB. Furthermore, the second operation amplifier has an inverting input 7 and an output which is connected to the inverting input of the first operation amplifier OP. The second resistor divider has a third and a fourth resistor R3, R4 which are coupled between the output of the second operation amplifier and the reference potential terminal 10. A connection point between third and fourth resistor R3, R4 is connected to the inverting input 7 of the second operation amplifier.

The current buffer component CB works in the same way as described above with reference to Figure 1. The voltage drop Vd across the resistor R is amplified with the second operation amplifier having a variable gain and thereby determines the virtual ground of the first operation amplifier. Thereby a voltage drop at the input 1 is also determined. The resulting input impedance can be calculated according to the following equation:

$$Rin = R * (1 + \frac{R3}{R4})$$

wherein Rin represents the input impedance Rin, R represents the resistor R, R3 represents the third resistor R3 and R4 represents the fourth resistor R4.

With respect to Figure 1, the roles of trimming and setting are swapped. Here, the resistor R can be used for trimming, whereas the second resistor divider, namely the third resistor R3 is used for setting the resistance value. Trimming is optional in this embodiment. It is to be noted that the current crossing the third resistor R3 can be chosen with a degree of freedom when compared to the input current Iin, as it is less than the input current Iin by the ratio of the fourth resistor R4 and the resistor R. Consequently, area is saved because switches do not need to be so large and it is no longer necessary to generate small resistors with many units in parallel.

Regarding the trimming, only the resistor R should be trimmed because it is the only element that ensures the proportionality to the input impedance Rin according to the above formula. However, the resistor R can be dimensioned very small, being for instance less than the smallest resistance value realized by the active potentiometer circuit.

Also, in this embodiment the offset of first and second operational amplifiers shall be corrected in order to ensure accuracy of the active potentiometer circuit.

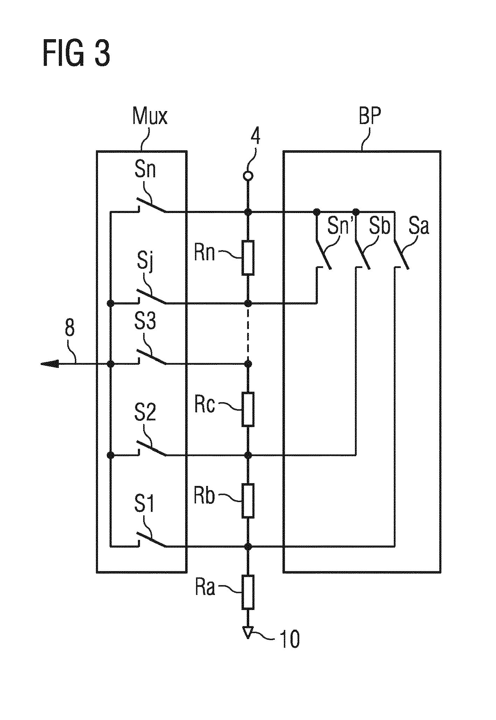

Figure 3 shows an example for implementing the resistor as proposed. The resistor comprises a serial connection of n partial resistors Ra, Rb, Rc, ..., Rn. This serial connection is coupled with one end to the output 4 of the current buffer component CB according to Figures 1 or 2. The other end of the serial connection is coupled to the reference potential terminal 10. The resistances of the n partial resistors are substantially equal. The resistor further comprises a multiplexer component Mux which has a number of n multiplexer switches S1, S2, S3, ..., Sj, Sn. Each multiplexer switch couples one connection point in the serial connection of partial resistors to an output 8 of the multiplexer component. Said output 8 is connected to the second buffer input 3 of the current buffer component CB according to Figure 1 or Figure 2.

The multiplexer component Mux selects the suitable tap that provides a desired value for the resistor R. As the output 8 of the multiplexer Mux is connected to an amplifier input with infinite impedance, the switches can be minimum sized. At the same time, the possibility to have any point of the circuit scaled down to low voltage range enables implementation of the switches of the multiplexer as transmission gates with CMOS logic in case this implementation of the variable resistor is used in the active potentiometer circuit of Figure 1.

Optionally, the resistor comprises a bypass circuit BP. This bypass circuit BP has a number of n bypass switches Sa, Sb, ..., Sn'. Each bypass switch is adapted to switchably bypass one corresponding partial resistor.

Without the bypass switches, the residual upper part of the serial connection of partial resistors would tend to push the source terminal of transistor MN, as of Figure 1 or the multiplier M output as of Figure 2, so high that there would not be enough dynamic range for correct operation. Therefore, said residual part is bypassed by means of the bypass circuit BP.

Of course it is not necessary to make these switches very large, even if they must sustain the entire current at the input 1 of the active potentiometer circuit. Their, switch-on resistance does not contribute to the final accuracy and they just should reduce the voltage drop Vd to leave some margin for the operation of the drain to source voltage of transistor MN or the multiplier M. The most critical condition is encountered whenever the lowest tap of the serial connection is selected, as the drain source voltage in this case amounts to the product of the resistor R and the input current Iin and the ratio of first and second resistors or third and fourth resistors. On the contrary, if a tap in the upper part of the serial connection is selected, the resistor R and, consequently, the drain source voltage of the transistor MN are so large as to allow the switch to be resistive or even omitted, which is the case for having first and second resistors or third and fourth resistors of equal size.

The accuracy of the resistance realized by the active potentiometer circuit as proposed with the realization of the resistor depicted in Figure 3 is independent of the turn on resistance of the switches employed in the circuit.

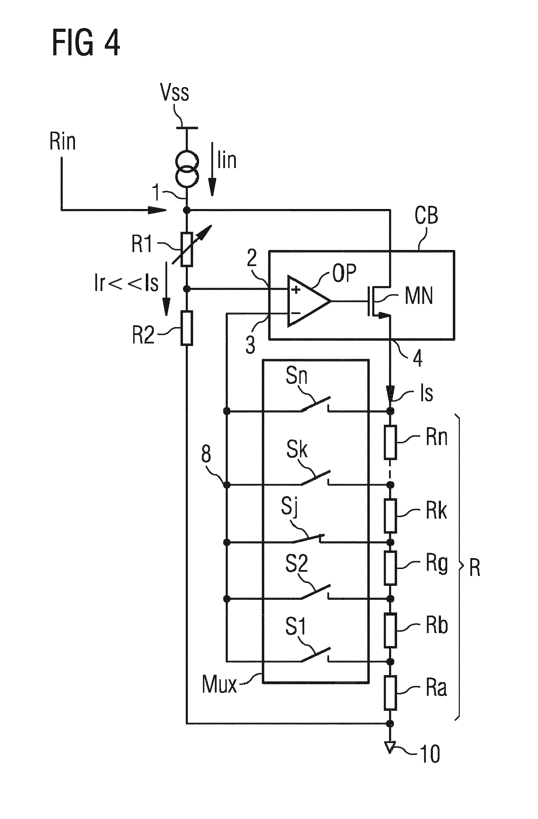

Figure 4 shows an exemplary embodiment of an active potentiometer circuit with an implementation of the resistor as proposed. Specifically, Figure 4 shows the active potentiometer circuit as of Figure 1 which uses the implementation of the resistor as depicted in Figure 3 without the bypass circuit. It can be seen that the output 8 of the multiplexer component Mux is coupled to the second buffer input 3 of the current buffer component CB. The resistor is realized by a number of n partial resistors Ra, Rb, ..., Rj, Rk, ..., Rn which are connected in series between the output 4 of the current buffer component CB and the reference potential 10. By this, the resistor R as of Figure 1 is split into n partial resistors with substantially equal resistances. Each of the partial resistors can be selected by means of one of the multiplexer switches. Therefore, the multiplexer component Mux has a number of n switches S1, S2, ..., Sj, Sk, ..., Sn. In the example depicted in Figure 4, a switch Sj is closed such that the partial resistors Ra, Rb, ..., Rj are selected to drive the second input 3 of the current buffer component CB, thereby driving the negative input of the first operational amplifier OP.

The equivalent input impedance Rin can be calculated by the following equation:

$$Rin = j * r * (1 + \frac{R1}{R2})$$

wherein Rin is the equivalent input impedance at the input 1, j represents the number j of the partial resistor Rj which is selected by the multiplexer switch Sj, r represents the resistance of any partial resistor, R1 represents the first resistor R1, and R2 represents the second resistor R2.

It can be seen that all of the partial resistors are crossed by the buffered current Is. By means of the multiplexer component Mux different voltages can be selected to enter the negative input of the first operational amplifier OP. The virtual ground of the first operational amplifier OP multiplies this voltage drop by the sum of one and the ratio of the first and the second resistor R1 and R2, so that the equivalent input impedance Rin directly depends on which of the multiplexer switches is closed.

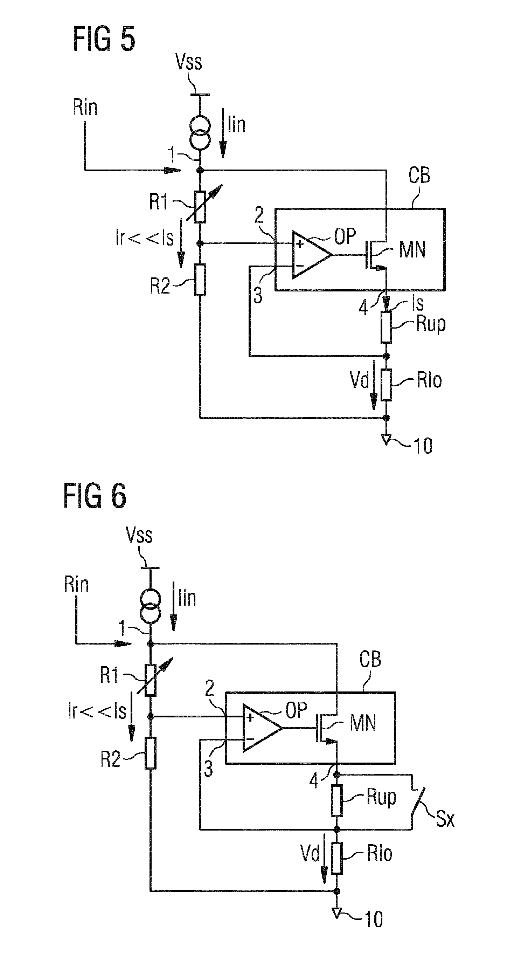

Figure 5 shows an equivalent circuit of the embodiment of Figure 4. Due to the closure of the switch Sj as shown in Figure 4, the resistor ladder between the output 4 of the current buffer component CB and the reference potential 10 is divided into an upper part which is represented by an upper resistor Rup and a lower part which is represented by a lower resistor Rlo. Only the lower part resistor Rlo provides a contribution to the voltage at the input 1, and hence determines the equivalent input impedance Rin as described above. The upper part of the resistor ladder represented by the upper resistor Rup with a resistance of the product of the difference between n and j with the basic resistance r does not contribute to the input equivalent impedance Rin. The voltage drop Vd across the lower resistor Rlo amounts to a product of the buffered current Is, the factor j and the basic resistance r.

Figure 6 shows another embodiment example of the active potentiometer circuit as proposed. The embodiment depicted in Figure 6 coincides with the embodiment shown in Figure 5 except for an additional bypass switch Sx. Bypass switch Sx is one of the bypass switches of the bypass circuit BP depicted in Figure 3. Bypass switch Sx is added to minimize the voltage drop across the residual upper resistor Rup. This also minimizes the voltage drop at a source terminal of transistor MN and leaves room for the transistor MN to operate in saturation.

Bypass switch Sx is especially advantageous in case that the residual resistance of the upper resistor Rup crosses a voltage drop which surpasses the voltage drop Vd on the selected lower resistor Rlo. Without the bypass switch Sx transistor MN would operate with a negative drain-to-source voltage in this case. This would cause the feedback loop between transistor MN and the first operational amplifier OP to open, the virtual ground would be lost and, finally, the equivalent input impedance value Rin would be altered. This is prevented by the bypass switch Sx.

It is to be noted that there is no need to achieve a very small voltage drop across the bypass switch Sx. It is sufficient to keep this voltage drop low enough to ensure a large enough value for the drain to source voltage of transistor MN. Usually, a voltage drop of about 20 to 50 millivolt is tolerable, as long as the number j of the selected partial resistor in the resistor ladder is not equal to zero and first and second resistors R1 and R2 are implemented with approximately equal resistance values.

It is to be understood that any feature described in relation to any one embodiment may be used alone, or in combination with other features described, and may also be used in combination with one or more features of any other of the embodiments, or any combination of any other of the embodiments unless described as alternative. Furthermore, equivalents and modifications not described above may also be employed without departing from the scope of the active potentiometer circuit which is defined in the accompanying claims.

Reference list

| | |
|---|---|
| 1, 2, 3, 4, 5, 6, 7, 8 | input/output |
| 10 | reference potential terminal |
| CB | current buffer component |
| Is, Iin, Ir | current |

| | |
|---|---|
| OP | operational amplifier |
| M | multiplier |
| Mux | multiplexer component |
| R | resistor |
| R1, R2, R3, R4 | resistor |
| MN | transistor |
| S1, S2, S3, Sj, Sn | multiplexer switch |
| Ra, Rb, Rc, Rn | partial resistor |
| BP | bypass circuit |
| Sa, Sb, Sn' | bypass switch |
| RA, RB, RC | fractional resistor |
| SB, SC, SN | shortening switch |
| R11, R12, R13, R1n | divisional resistor |
| S11, S12, S13, S1n | eliminating switch |
| Vss | supply potential terminal |
| Vd | voltage drop |
| Rup, Rlo | resistor |

**Claims**

1. Active potentiometer circuit having
   an input (1) which is adapted to receive an input current (Iin),
   a current buffer component (CB) which has a first buffer input (2) which is coupled to the input (1), a second buffer input (3) and a buffer output (4) at which a buffered current (Is) is provided as a function of the input current (Iin), and
   a resistor (R) which is coupled between the current buffer output (4) and a reference potential terminal (10),
   wherein the buffer output (4) is coupled to the second buffer input (3) and a voltage drop (Vd) across the resistor (R) is coupled to the second buffer input (3) such that a potential of the first buffer input (2) is adjusted to a potential at the second buffer input (3).

2. Active potentiometer circuit according to claim 1,
   wherein the current buffer component (CB) comprises a first operational amplifier (OP) and a transistor (MN) coupled to an output of the first operational amplifier (OP).

3. Active potentiometer circuit according to claim 2,
   wherein a positive input terminal of the first operational amplifier (OP) forms the first buffer input (2), a negative input terminal of the first operational amplifier (OP) forms the second buffer input (3) and an output (5) of the first operational amplifier is coupled to a control input of the transistor (MN), and
   wherein a controlled section of the transistor (MN) is connected between the input (1) of the active potentiometer circuit and the buffer output (4) of the current buffer component (CB).

4. Active potentiometer circuit according to any of claims 1 to 3,
   wherein a resistor divider (R1, R2) is provided having a first and a second resistor (R1, R2) being connected in series between the input (1) of the active potentiometer circuit and the reference potential terminal (10) such that the first buffer input (2) is coupled to the active potentiometer circuit input (1) by means of the first resistor (R1).

5. Active potentiometer circuit according to claim 4,
   wherein one of first and second resistors (R1, R2) has an adjustable resistance value.

6. Active potentiometer circuit according to any of claims 1 to 3,
   wherein a multiplier component (M) is provided which is connected between the buffer output (4) and the second buffer input (3), and
   wherein the input (1) of the active potentiometer circuit is directly connected to the first current buffer input (2).

7. Active potentiometer circuit according to claim 6,
   wherein the multiplier component (M) comprises a second operational amplifier with a non-inverting input terminal (6) which is coupled to the current buffer output (4), an inverting input terminal (7) and an output which is connected to the second buffer input (3).

8. Active potentiometer circuit according to claim 7,
   wherein a second resistor divider (R3, R4) is provided having a third and a fourth resistor (R3, R4) being connected in series between the output of the second operational amplifier and the reference potential terminal (10), and wherein a connection point between third and fourth resistor (R3, R4) is coupled to the inverting input terminal (7) of the second operational amplifier.

9. Active potentiometer circuit according to claim 8,
   wherein one of third and fourth resistors (R3, R4) has an adjustable resistance value.

10. Active potentiometer circuit according to any of claims 1 to 9, wherein the resistor (R) has a digitally adjustable resistance value.

11. Active potentiometer circuit according to any of claims 1 to 10,
    wherein the resistor (R) comprises a serial connection of an amount of n partial resistors (Ra, Rb, Rc, Rn), the resistances of the n partial resistors being substantially equal, and the resistor (R) further comprises a multiplexer component (Mux) which has a number of n multiplexer switches (S1, S2, S3, Sj, Sn), each multiplexer switch coupling one connection point in the serial connection of partial resistors (Ra, Rb, Rc, Rn) to an output (8) of the multiplexer component (Mux), wherein said output (8) is connected to the second buffer input (3).

12. Active potentiometer circuit according to claim 11,
    wherein the resistor (R) further comprises a bypass circuit (BP) having a number of n bypass switches (Sa, Sb, Sn'), each bypass switch being coupled between the buffer output (4) and the reference potential terminal (10), wherein each bypass switch (Sa, Sb, Sn') is adapted to bypass the corresponding partial resistor (Ra, Rb, Rc, Rn) in a switchable manner.

13. Active potentiometer circuit according to any of claims 1 to 10,
    wherein the resistor (R) comprises a serial connection of an amount of n fractional resistors (RA, RB, RC, RN), and a number of n minus one shortening switches (SB, SC, SN), each shortening switch being adapted to connect one connection point between two fractional resistors of the serial connection to the reference potential terminal (10) in a switchable manner, wherein the resistances of the n fractional resistors are substantially equal.

14. Active potentiometer circuit according to any of claims 1 to 10,
    wherein the resistor (R) comprises a serial connection of an amount of n divisional resistors (R11, R12, R13, R1n), and a number of n eliminating switches (S11, S12, S13, S1n), each eliminating switch being adapted to bypass the corresponding divisional resistor in a switchable manner, wherein the resistance of each of the n divisional resistors corresponds to the product of an adjustable basic resistance value and two to the power of the position of the corresponding divisional resistor such that binary weighted taps are formed within the serial connection of divisional resistors.

## FIG 1

## FIG 2

FIG 3

FIG 4

FIG 5

FIG 6

# FIG 7

# FIG 8

Europäisches
Patentamt

European
Patent Office

Office européen
des brevets

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 4 833 472 A (HANNAPPEL JOACHIM [DE] ET AL) 23 May 1989 (1989-05-23) * figures 1,2 * | 1-14 | INV. G05F1/575 |
| X | US 5 083 043 A (YOSHIDA MAKOTO [JP]) 21 January 1992 (1992-01-21) | 1,2 | |
| A | * column 1, line 15 - line 64; figure 1 * | 3-14 | |
| A | Microchip: "Tips 'n Tricks 3V", , 16 March 2006 (2006-03-16), pages 1-56, XP055275786, Chandler, AZ 85224 U.S.A Retrieved from the Internet: URL:http://www.newark.com/pdfs/techarticle s/microchip/3_3vto5vAnalogTipsnTricksBrchr .pdf [retrieved on 2016-05-26] * page 34 - page 35; figures 16-2 * | 1-14 | |

TECHNICAL FIELDS
SEARCHED      (IPC)

G05F

The present search report has been drawn up for all claims

| Place of search | Date of completion of the search | Examiner |
|---|---|---|
| The Hague | 27 May 2016 | O'Reilly, Siobhan |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 15 20 1321

This annex lists the patent family members relating to the patent documents cited in the above-mentioned European search report.
The members are as contained in the European Patent Office EDP file on
The European Patent Office is in no way liable for these particulars which are merely given for the purpose of information.

27-05-2016

| Patent document cited in search report | | Publication date | Patent family member(s) | | Publication date |
|---|---|---|---|---|---|
| US 4833472 | A | 23-05-1989 | BR | 8704721 A | 03-05-1988 |
| | | | DE | 3631285 A1 | 24-03-1988 |
| | | | EP | 0260346 A2 | 23-03-1988 |
| | | | US | 4833472 A | 23-05-1989 |
| US 5083043 | A | 21-01-1992 | JP | H087636 B2 | 29-01-1996 |
| | | | JP | H03214212 A | 19-09-1991 |
| | | | US | 5083043 A | 21-01-1992 |

EPO FORM P0459

For more details about this annex : see Official Journal of the European Patent Office, No. 12/82